# EUROPÄISCHE PATENTSCHRIFT

(11) **EP 2 195 672 B1**
(45) Veröffentlichungstag und Bekanntmachung des Hinweises auf die Patenterteilung: **25.05.2011**
(21) Anmeldenummer: 08804246.0
(22) Anmeldetag: 16.09.2008
(51) Int. Cl.: G01R 31/30, G01R 31/3187

(54) **VERFAHREN ZUM TESTEN**
TESTING METHOD
PROCÉDÉ DE TEST

(30) Priorität: 01.10.2007 DE 102007047024
(43) Veröffentlichungstag der Anmeldung: 16.06.2010
(73) Patentinhaber: Robert Bosch GmbH, 70442 Stuttgart (DE)
(72) Erfinder: RANDOLL, Helmut, 71665 Vaihingen (DE); AUE, Axel, 70825 Muenchingen (DE); WIEJA, Thomas, 72810 Gomaringen (DE); POSCHALKO, Christian, A-1160 Wien (AT); WIRTH, Steffen, 70469 Stuttgart (DE); FRIEDHOFF, Wilhelm, 31167 Bockenem (DE)
(86) Internationale Anmeldenummer: PCT/EP2008/062288
(87) Internationale Veröffentlichungsnummer: WO 2009/047089

(56) Entgegenhaltungen:
- US-A- 5 726 997
- US-A- 5 982 189
- US-A1- 2002 190 742
- US-A1- 2006 259 840

## Beschreibung

Die Erfindung betrifft ein Verfahren zum Testen, ein elektronisches Bauelement sowie ein Computerprogramm und ein Computerprogrammprodukt.

### Stand der Technik

Die stetig steigenden Anforderungen an die Qualität von elektronischen Systemen hat insbesondere im Halbleiterbereich zu erheblichen Anstrengungen bei der Entwicklung von Testverfahren geführt. Da mit den Herstellungsprozessen von Halbleitern eine endliche Defektdichte verbunden ist, ist eine unmittelbare Abhängigkeit der Produktqualität von der Leistungsfähigkeit der angewendeten Testverfahren gegeben. Demnach ist eine möglichst vollständige Prüfung aller für eine jeweilige Anwendung relevanten Merkmale erforderlich.

Der vergleichsweise hohe Kostenanteil der Bauelementeprüfungen an den Stückkosten, der sich u. a. aus der hierfür erforderlichen Testzeit ergibt, führt zu einer Verlagerung von Testverfahren in die Bauelemente in Form von sog. "DFT"(Design for Test) - Maßnahmen. Die fortschreitende Komplexitätssteigerung der Bauelemente durch Strukturweitenreduktion führt dazu, dass zunehmend leistungsfähigere "On Chip"-Testhilfen eingesetzt werden, die üblicherweise an einem gefertigten Bauelement durchgeführt werden.

Die Druckschrift US 2006/259840 A1 beschreibt einen Selbsttest-Schaltkreis zum Bestimmen einer minimalen Betriebsspannung, mit diesem ist es möglich, eine Versorgungsspannung in Halbleiterschaltkreisen zu verringern, um den Verbrauch zu reduzieren, währenddessen die Leistungsfähigkeit der Halbleiterschaltkreise gewahrt bleibt. Hierzu wird der Selbsttest-Schaltkreis verwendet, der die geringste Betriebsspannung bestimmt, bei der die Betriebsfähigkeit gewährleistet ist und es wird ein diese geringst mögliche Betriebsspannung repräsentierendes Steuersignal ausgegeben.

### Offenbarung der Erfindung

Die Erfindung betrifft ein Verfahren zum Testen, das mit mindestens einem elektronischen Bauelement, das in einer elektronischen Baugruppe integriert und durch spezifische Testfunktionen zur Variation von Betriebsbedingungen schaltungstechnisch erweitert ist, ausgeführt wird. Bei dem Verfahren wird zur Variation der Betriebsbedingungen eine Versorgungsspannung für das mindestens eine Bauelement variiert, wobei in einem ersten Verfahrensschritt die Versorgungsspannung über mindestens einen Nominalwert angehoben wird, in einem zweiten Verfahrensschritt eine Abarbeitung einer Prüfroutine für eine maximale Dauer erfolgt, in einem dritten Verfahrensschritt die Versorgungsspannung unter einen Nominalwert abgesenkt wird, in einem vierten Verfahrensschritt ein Abarbeiten der Prüfroutinen ausgehend von der im dritten Verfahrensschritt getroffenen Maßnahmen durchgeführt wird, in einem fünften Verfahrensschritt ein Betrieb bei Nominalwerten ohne Ablage erfolgt und in einem sechsten Verfahrensschritt ein Abarbeiten der Prüfroutinen unter Berücksichtigung der im fünften Verfahrensschritt getroffenen Maßnahmen durchgeführt wird.

Mit diesem Verfahren kann mindestens ein Bauelement der Baugruppe und somit ggf. auch die komplette Baugruppe getestet werden, wobei mehrere Bauelemente der elektronischen Baugruppe üblicherweise gleichzeitig getestet werden.

Zur Variation der Betriebsbedingungen können unterschiedliche, für einen Betrieb erforderliche, elektronische Betriebsparameter, wie bspw. eine Versorgungsspannung oder ggf. eine Stromstärke, für das mindestens eine Bauelement variiert werden.

Die zur Ausführung des Verfahrens u. a. vorgesehenen Testfunktionen können über mindestens einen Kommunikationskanal, der innerhalb der elektronische Baugruppe mit dem mindestens einen schaltungstechnisch erweiterten, elektronischen Bauelement verbunden ist, modifiziert werden. Über den mindestens einen Kommunikationskanal ist das mindestens eine schaltungstechnisch erweiterte Bauelement mit mindestens einem weiteren Bauelement verbunden.

In Ausgestaltung des Verfahrens ist vorgesehen, dass durch das mindestens eine schaltungstechnisch erweiterte, elektronische Bauelement mindestens ein weiteres elektronisches Bauelement, das in der elektronischen Baugruppe integriert ist, getestet wird. Alternativ oder ergänzend kann das mindestens eine elektronische Bauelement einen Selbsttest durchführen.

Weiterhin ist es möglich, durch das mindestens eine elektronische Bauelement, das schaltungstechnisch erweitert ist, Referenzen abzugleichen.

Das schaltungstechnisch erweiterte Bauelement ist in der elektronischen Baugruppe, die in der Regel mehrere Bauelemente umfasst, eingebaut. Für eine Erweiterung einer Teststrategie für mindestens ein Bauelement und somit ggf. auch der elektronischen Baugruppe wird zur Variation von Betriebsbedingungen eine spezifische Testhilfe bzw. - funktion für das mindestens eine Bauelement eingesetzt.

Eine Testfunktion umfasst üblicherweise eine Variation mindestens einer Versorgungsspannung, insbesondere jener Versorgungsspannungen, die für die Baugruppenprüfung in verbautem Zustand bereitgestellt werden.

In Ausgestaltung ist es weiterhin möglich, dass die Betriebsbedingungen durch das mindestens eine schaltungstechnisch erweiterte, elektronische Bauelement variiert werden.

Das mindestens eine schaltungstechnisch erweiterte, elektronische Bauelement kann in einer Ausführungsform der Erfindung als ein ggf. modifizierter BIST (built-in-self-test) - Baustein ausgebildet sein, dessen Funktion nicht allein darauf beschränkt ist, lediglich einen Selbsttest durchzuführen. Das Bauelement bzw. der Baustein ist derart schaltungstechnisch erweitert, dass darin mindestens eine Testfunktion implementiert ist, so dass das Bauelement sich selbst und/oder andere Bauelemente der Baugruppe testen kann. Eine derartige Implementierung kann softwaretechnisch erfolgen. Ein Programm zur Durchführung der Testfunktion kann in dem mindestens einen schaltungstechnisch erweiterten Bauelement gespeichert und bedarfsweise wieder gelöscht werden.

Das mindestens eine Bauelement oder ein entsprechendes Schaltungsteil ist derart erweitert, dass während des Tests, bspw. nach einem Abgleichschritt, Betriebsparameter konfiguriert werden.

In einer Variante des Verfahrens kann ein Zugriff auf das mindestens eine Bauelement über eine Schnittstelle, insbesondere über eine Test- oder Kommunikationsschnittstelle, der elektronischen Baugruppe erfolgen.

Das Verfahren kann u. a. für mindestens ein als Halbeleiterelement ausgebildetes Bauelement, das in einer als Steuergerät ausgebildeten elektronische Baugruppe integriert ist, ausgeführt werden.

Die Erfindung betrifft außerdem ein elektronisches Bauelement, das in einer elektronischen Baugruppe integriert und zur Variation von Betriebsbedingungen durch spezifische Testfunktionen schaltungstechnisch erweitert ist, so dass dieses elektronische Bauelement zur Durchführung eines Verfahrens der vorstehend beschriebenen Art ausgebildet ist.

Dabei kann das elektronische Bauelement dazu ausgebildet sein, mindestens ein weiteres elektronisches Bauelement, dass in der Baugruppe integriert ist, zu testen und/oder einen Selbsttest durchzuführen.

Eine vorgesehene elektronische Baugruppe weist mindestens ein erfindungsgemäßes elektronisches Bauelement auf.

Das mindestens eine erfindungsgemäße Bauelement ist zur Durchführung von wenigstens einem Schritt des erfindungsgemäßen Verfahrens ausgebildet. Demnach kann dieser wenigstens eine Schritt auch durch die erfindungsgemäße elektronische Baugruppe ausgeführt werden. Dieses schaltungstechnisch erweiterte Bauelement kann bspw. als Controller bzw. Kontrollmodul oder Versorgungseinheit ausgebildet sein. Die Erfindung betrifft außerdem ein Computerprogramm mit Programmcodemitteln, um alle Schritte eines erfindungsgemäßen Verfahrens durchzuführen, wenn das Computerprogramm auf einem Computer oder einer entsprechenden Recheneinheit, insbesondere in einer beschriebenen elektronischen Baugruppe, ausgeführt wird.

Das erfindungsgemäße Computerprogrammprodukt mit Programmcodemitteln, die auf einem computerlesbaren Datenträger gespeichert sind, ist zum Durchführen aller Schritte eines beschriebenen Verfahrens ausgebildet, wenn das Computerprogramm auf einem Computer oder einer entsprechenden Recheneinheit, insbesondere in einer vorgestellten elektronischen Baugruppe, ausgeführt wird.

Die Erfindung ermöglicht bspw. ein Testverfahren für ein Steuergerät mit variablen Betriebsbedingungen.

In Ausgestaltung der Erfindung kann in der elektronischen Baugruppe eine sog. "BIST"- bzw. built-in-self-test-Struktur implementiert sein, die als ein elektronischer Baustein und somit der schaltungstechnisch erweiterten Baugruppe zur Durchführung des Tests sowie eines Selbsttests ausgebildet ist. Diese primär für den Test von integrierten Schaltkreisen konzipierten Strukturen zum Ausführen des Tests lassen sich bei der Erfindung typischerweise auch zum Test der Baugruppe einsetzten. Ein Einsatz des beschriebenen schaltungstechnisch erweiterten elektronischen Bauelements bietet sich u. a. bei der Implementierung von elektronischen Baugruppen mit integrierten Versorgungsbausteinen an.

Mit der Erfindung können u. a. Qualitätsanforderungen auf Ebene der Baugruppe zur Verbesserung der Prüftiefe der Bauelemente im Schaltungsverbund sowie bei der Prüfung der Bauelemente nach einer Gerätefertigung erfüllt werden. Eine mögliche Variante des Verfahrens sieht die Anwendung von BIST-Strukturen von Bauelementen zum Selbsttest in einer Applikation, wie z.B. im IEEE Standard 1149.1 beschrieben, vor, wobei ebenfalls Betriebsbedingungen variiert werden können.

Bei der elektrischen Prüfung der elektronischen Baugruppe bzw. von einzelnen Bauelementen der Baugruppe in verbautem Zustand, können nunmehr wie bei der Prüfung isolierter Bauelemente die Betriebsbedingungen, insbesondere Betriebsparameter wie die Versorgungsspannungen, variiert werden.

Eine Ausführung der Erfindung beruht somit auf der schaltungstechnischen Erweiterung von Bauelementen und somit von Baugruppen durch spezifische Testfunktionen zur Variation der Betriebsbedingungen, die für die Baugruppenprüfung in verbautem Zustand bereitgestellt werden. Dabei können existierende Funktionen bzw. vorhandene Testhilfen so modifiziert werden, dass sie über die bestehenden Kommunikationskanäle kontrolliert werden. Beispielsweise können Schaltungsteile, die primär einem Abgleich von Referenzen oder Spannungsquellen dienen, so erweitert werden, dass auch nach einem Abgleichschritt eine Möglichkeit zur Konfiguration der entsprechenden Parameter geschaffen wird.

Ein Zugriff auf die Testfunktion erfolgt vorzugsweise über eine Testschnittstelle oder ein Testinterface, wie es beispielsweise auch im IEEE Standard 1149.1 beschrieben ist. Alternativ oder ergänzend kann der Zugriff über eine vorhandene interne Kommunikationsschnittstelle eines jeweiligen elektronischen Bauelements erfolgen.

Bei der Prüfung des mindestens einen Bauelements und ggf. der Baugruppe werden in Ausgestaltung vorhandene "built-in-self-test"-Funktionen bzw. Test- oder Selbsttest-Routinen der Geräte-Software bei unterschiedlichen Betriebsbedingungen ausgeführt. Dabei können sowohl digitale wie auch analoge Merkmale der Baugruppe in die Prüfung einbezogen werden.

Bei einer Variante der Erfindung kann sich die Prüfung mit unterschiedlichen Betriebsbedingungen vorteilhaft auf die Prüftiefe auswirkt. Außerdem kann durch Prüfung mit Variation der Versorgungsspannung das Problem von nicht erkennbaren Fehlfunktionen beim Betrieb in Grenzlagen bzw. in Grenzbereichen bzgl. einer physikalischen Belastbarkeit weitgehend behoben werden.

Bei einem Testbetrieb mit erhöhter Versorgungsspannung für die Baugruppen in Relation zum Normalbetrieb wird die Baugruppe einem elektrischen und thermischen Stress ausgesetzt, der zur Aktivierung latenter Schwachstellen genutzt wird, wohingegen eine Prüfung mit abgesenkter Versorgungsspannung Testbedingungen in Bezug auf Treiberfähigkeit, Schaltgeschwindigkeit und Störempfindlichkeit, bspw. bei der Prüfung analoger Leistungsmerkmale, definiert.

Zur Durchführung einer Variante des Verfahrens wird üblicherweise ein Schaltungsteil benutzt, der auch als Bauelement ausgebildet sein kann, zur Bereitstellung der erforderlichen Versorgungsspannungen der Baugruppe dient und in elektronischen Baugruppen enthalten sein kann.

Weitere Vorteile und Ausgestaltungen der Erfindung ergeben sich aus der Beschreibung und der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Kurze Beschreibung der Zeichnung

Figur 1 zeigt in schematischer Darstellung eine beispielhafte Ausführung einer elektronischen Baugruppe.
Figur 2 zeigt in schematischer Darstellung ein Diagramm zu einer Ausführungsform zur Durchführung des erfindungsgemäßen Verfahrens.

### Ausführungsformen der Erfindung

Die Erfindung ist anhand von Ausführungsbeispielen in der Zeichnung schematisch dargestellt und wird im Folgenden unter Bezugnahme auf die Zeichnung ausführlich beschrieben.

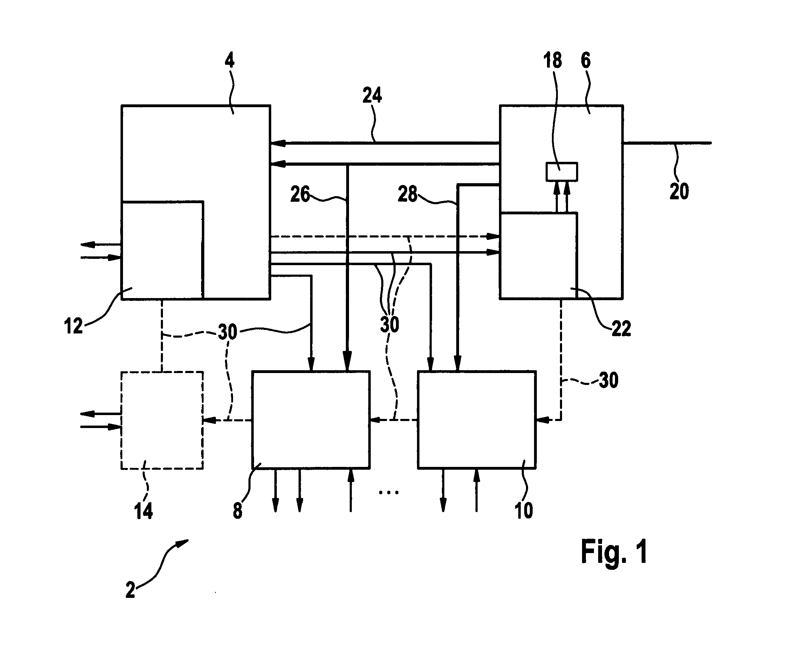

Die in Figur 1 schematisch dargestellte beispielhafte Ausführung einer elektronischen Baugruppe 2 umfasst als Bauelemente einen Controller 4, eine Versorgungseinheit 6 sowie eine erste Peripherieeinheit 8 und eine n-te Peripherieeinheit 10, die hier als zu testende Bauelemente vorgesehen sind. Der Controller 4 weist eine externe Kommunikationsschnittstelle 12 auf, die über einen Anschluss der Baugruppe 2 zugänglich ist.

Die hier beschriebene Ausführungsform der Baugruppe 2 weist zusätzlich eine Testschnittstelle 14 auf. Die Baugruppe 2 ist hier zugleich als ein Steuergerät ausgebildet. Falls dieses Steuergerät nicht durch ein Abdeckelement geschlossen ist, kann auf die Testschnittstelle 14 direkt oder mittelbar über eine externe Schnittstelle der Baugruppe 2 zugegriffen werden.

Die Versorgungseinheit 6 weist eine konfigurierbare Einheit 18 zum Variieren von Spannungen von Versorgungssystemen 24, 26, 28, die über eine Versorgungsleitung 20 bereitgestellt werden, sowie eine Schnittstelle 22 auf. Somit ist diese Versorgungseinheit 6 als eine Ausgestaltung eines schaltungstechnisch erweiterten Bauelements ausgebildet.

Während einer Prüfung der Baugruppe 2 wird in diesem Fall über die Kommunikationsschnittstelle 12 des Controllers 4 eine Ablage von Versorgungssystemen 24, 26, 28 in der Versorgungseinheit 6 aktiviert. Alternativ kann eine derartige Ablage über die Testschnittstelle 14 aktiviert werden. Außerdem sind die beschriebenen Komponenten der Baugruppe über mehrere Kommunikationskanäle 30 miteinander verbunden.

Die Prüfung der Baugruppen 2 erfolgt schrittweise durch wiederholte Ausführung der vollständigen Testroutinen des Controllers 4 und somit der im Controller 2 vorhandenen BIST-Funktionen bzw. eingebauter Funktionen zum Test der einzelnen Bauelemente, zur Prüfung analoger Parameter sowie ggf. verfügbarer Verdrahtungsprüfungen bei unterschiedlichen Versorgungsspannungen. Demnach ist hier weiterhin der Controller 4 als eine weitere Ausgestaltung eines schaltungstechnisch erweiterten Bauelements ausgebildet.

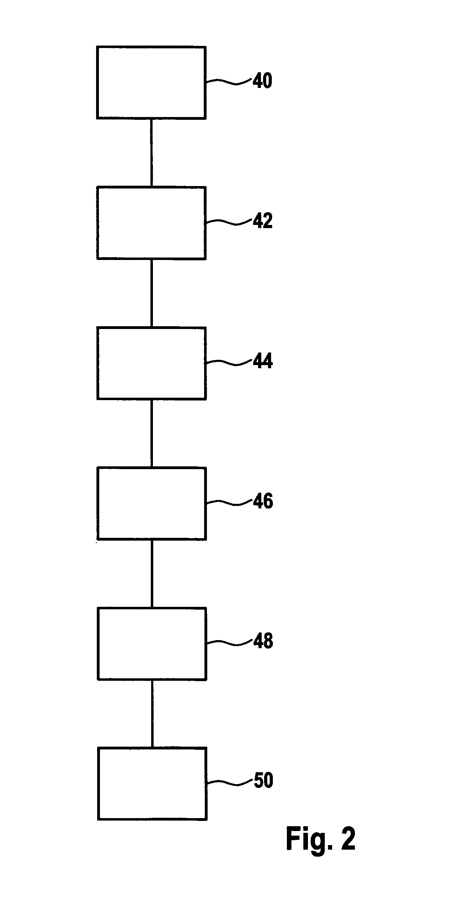

Die Versorgungseinheit 6 sowie der Controller 2 sind hier jeweils durch spezifische Testfunktionen schaltungstechnisch erweitert. Somit sind diese beiden schaltungstechnisch erweiterten Bauelemente zum Testen der Peripherieeinheiten 6, 8 ausgebildet. Das in Figur 2 schematisch dargestellte Diagramm zur Durchführung einer Ausführungsform des erfindungsgemäßen Verfahrens umfasst in einem ersten Verfahrensschritt 40 ein Anheben der Versorgungsspannung über mindestens einen Nominalwert. In einem zweiten Verfahrensschritt 42 erfolgt eine Abarbeitung einer Prüfroutine für eine maximale Dauer, wobei hier eine thermische und elektrische Beanspruchung zur Aktivierung latenter Defekte einer elektronischen Baugruppe vorgesehen ist.

In einem dritten Verfahrensschritt 44 wird die Versorgungsspannung unter einen Nominalwert abgesenkt, wobei hier eine Prüfung mit Vorhalt bezüglich Pegel und Schaltgeschwindigkeit vorgesehen ist. Eine Abarbeitung der Prüfroutinen ausgehend von der im dritten Verfahrensschritt 44 getroffenen Maßnahme wird in einem vierten Verfahrensschritt 46 durchgeführt.

In einem fünften Verfahrensschritt 48 erfolgt ein Betrieb bei Nominalwerten ohne Ablage. Ein Abarbeiten der Prüfroutinen wird in einem sechsten Verfahrensschritt 50 unter Berücksichtigung der im fünften Verfahrensschritt 48 getroffenen Maßnahmen durchgeführt.

Die einzelnen Verfahrensschritte 40, 42, 44, 46, 48, 50 werden in Ausgestaltung der Erfindung durch ein Bauelement durchgeführt, das in der Baugruppe integriert ist. Dieses Bauelement ist durch spezifische Testfunktionen schaltungstechnisch erweitert, die es erlauben, die Verfahrungsschritte 40, 42, 44, 46, 48, 50 unter Variation von Betriebsbedingungen, hier Anheben und Absenken der Versorgungsspannung, durchzuführen.

## Patentansprüche

1. Verfahren zum Testen, das mit mindestens einem elektronischen Bauelement, das in einer elektronischen Baugruppe (2) integriert und durch spezifische Testfunktionen zur Variation von Betriebsbedingungen schaltungstechnisch erweitert ist, ausgeführt wird, bei dem zur Variation der Betriebsbedingungen eine Versorgungsspannung für das mindestens eine Bauelement variiert wird, **dadurch gekennzeichnet, dass** in einem ersten Verfahrensschritt die Versorgungsspannung über mindestens einen Nominalwert angehoben wird, in einem zweiten Verfahrensschritt eine Abarbeitung einer Prüfroutine für eine maximale Dauer erfolgt, in einem dritten Verfahrensschritt die Versorgungsspannung unter einen Nominalwert abgesenkt wird, in einem vierten Verfahrensschritt ein Abarbeiten der Prüfroutinen ausgehend von der im dritten Verfahrensschritt getroffenen Maßnahmen durchgeführt wird, in einem fünften Verfahrensschritt ein Betrieb bei Nominalwerten ohne Ablage erfolgt und in einem sechsten Verfahrensschritt ein Abarbeiten der Prüfroutinen unter Berücksichtigung der im fünften Verfahrensschritt getroffenen Maßnahmen durchgeführt wird.

2. Verfahren nach Anspruch 1, bei dem die Testfunktionen über mindestens einen Kommunikafionskanal (30), der innerhalb der elektronische Baugruppe mit dem mindestens einen schaltungstechnisch erweiterten, elektronischen Bauelement verbunden ist, modifiziert werden.

3. Verfahren nach einem der voranstehenden Ansprüche, bei dem durch das mindestens eine schaltungstechnisch erweiterte elektronische Bauelement mindestens ein weiteres elektronisches Bauelement, das in der elektronischen Baugruppe (2) integriert ist, getestet wird.

4. Verfahren nach einem der voranstehenden Ansprüche, bei dem das mindestens eine schaltungstechnisch erweiterte elektronische Bauelement einen Selbsttest durchführt.

5. Verfahren nach einem der voranstehenden Ansprüche, bei dem durch das mindestens eine schaltungstechnisch erweiterte elektronische Bauelement Referenzen abgeglichen werden.

6. Verfahren nach einem der voranstehenden Ansprüche, das für mindestens ein als Halbeleiterelement ausgebildetes Bauelement, das in einer als Steuergerät ausgebildeten elektronische Baugruppe (2) integriert ist, ausgeführt wird.

7. Elektronisches Bauelement, das in einer elektronischen Baugruppe (2) integriert und zur Variation von Betriebsbedingungen durch spezifische Testfunktionen schaltungstechnisch erweitert ist, **dadurch gekennzeichnet, dass** dieses elektronische Bauelement zur Durchführung eines Verfahrens nach einem der Ansprüche 1 bis 6 ausgebildet ist.

8. Elektronisches Bauelement nach Anspruch 7, das dazu ausgebildet ist, mindestens ein weiteres elektronisches Bauelement, das in der Baugruppe (2) integriert ist, zu testen.

9. Elektronisches Bauelement nach Anspruch 7 oder 8, das dazu ausgebildet ist, einen Selbsttest durchzuführen.

10. Computerprogramm mit Programmcodemitteln, um alle Schritte eines Verfahrens nach einem der Ansprüche 1 bis 6 durchzuführen, wenn das Computerprogramm auf einem Computer oder einer entsprechenden Recheneinheit, insbesondere in einer elektronischen Baugruppe (2), ausgeführt wird.

11. Computerprogrammprodukt mit Programmcodemitteln, die auf einem computerlesbaren Datenträger gespeichert sind, um alle Schritte eines Verfahrens nach einem der Ansprüche 1 bis 6 durchzuführen, wenn das Computerprogramm auf einem Computer oder einer entsprechenden Recheneinheit, insbesondere in einer elektronischen Baugruppe (2), ausgeführt wird.

## Claims

1. Method for testing which is carried out using at least one electronic component that is integrated in an electronic assembly (2) and that is extended in terms of circuitry by specific test functions for the purpose of varying operating conditions, in which the operating conditions are varied by varying a supply voltage for the at least one component, **characterized in that** in a first method step the supply voltage is raised above at least one nominal value, in a second method step an examination routine is executed for a maximum period, in a third method step the supply voltage is lowered below a nominal value, in a fourth method step the examination routine is executed on the basis of the measures taken in the third method step, in a fifth method step nominal values are used for operation without dumping and in a sixth method step the examination routines are executed taking account of the measures taken in the fifth method step.

2. Method according to Claim 1, in which the test functions are modified using at least one communication channel (30) which is connected within the electronic assembly to the at least one electronic component that has been extended in terms of circuitry.

3. Method according to one of the preceding claims, in which the at least one electronic component that has been extended in terms of circuitry tests at least one further electronic component which is integrated in the electronic assembly (2).

4. Method according to one of the preceding claims, in which the at least one electronic component that has been extended in terms of circuitry performs a self-test.

5. Method according to one of the preceding claims, in which the at least one electronic component that has been extended in terms of circuitry aligns references.

6. Method according to one of the preceding claims, which is carried out for at least one component that is in the form of a semiconductor element and that is integrated in an electronic assembly (2) in the form of a controller.

7. Electronic component which is integrated in an electronic assembly (2) and is extended in terms of circuitry by specific test functions for the purpose of varying operating conditions, **characterized in that** said electronic component is designed to perform a method according to one of Claims 1 to 6.

8. Electronic component according to Claim 7, which is designed to test at least one further electronic component that is integrated in the assembly (2).

9. Electronic component according to Claim 7 or 8, which is designed to perform a self-test.

10. Computer program having program code means in order to perform all the steps of a method according to one of Claims 1 to 6 when the computer program is executed on a computer or an appropriate computation unit, particularly in an electronic assembly (2).

11. Computer program product having program code means which are stored on a computer-readable data storage medium in order to perform all the steps of a method according to one of Claims 1 to 6 when the computer program is executed on a computer or an appropriate computation unit, particularly in an electronic assembly (2).

## Revendications

1. Procédé de test exécuté avec au moins un composant électronique intégré dans un module électronique (2) et complété par un circuit, le composant électronique présentant des fonctions de test spécifiques qui modifient les conditions de fonctionnement, et dans lequel pour modifier les conditions de fonctionnement, une tension d'alimentation du ou des composants est modifiée,
**caractérisé en ce que**
dans une première étape du procédé, la tension d'alimentation est relevée au-dessus d'au moins une valeur nominale, dans une deuxième étape de procédé, l'exécution d'une routine de vérification a lieu pendant une durée maximale, dans une troisième étape de procédé, la tension d'alimentation est abaissée en dessous d'une valeur nominale, dans une quatrième étape du procédé, l'exécution des routines de vérification est exécutée en partant des dispositions prises au cours de la troisième étape du procédé, dans une cinquième étape du procédé a lieu un fonctionnement aux valeurs nominales sans déviation et dans une sixième étape du procédé, un traitement des routines de vérification est exécuté sans tenir compte des dispositions prises dans la cinquième étape du procédé.

2. Procédé selon la revendication 1, dans lequel les fonctions de test sont modifiées par l'intermédiaire d'au moins un canal de communication (30) relié à l'intérieur du module électronique au composant ou aux composants électroniques complétés par un circuit.

3. Procédé selon l'une des revendications précédentes, dans lequel au moins un autre composant électronique intégré dans le module électronique (2) est testé par le ou les composants électroniques complétés par un circuit.

4. Procédé selon l'une des revendications précédentes, dans lequel le ou les composants électroniques complétés par un circuit exécutent un auto-test.

5. Procédé selon l'une des revendications précédentes, dans lequel des références sont égalisées par le ou les composants électroniques complétés par un circuit.

6. Procédé selon l'une des revendications précédentes, exécuté pour au moins un composant qui est configuré comme élément semi-conducteur et qui est intégré dans un module électronique (2) configuré comme appareil de commande.

7. Composant électronique intégré dans un module électronique (2) et complété par un circuit, qui fait varier les conditions de fonctionnement par des fonctions de test spécifiques,
**caractérisé en ce que**
ce composant électronique est configuré pour exécuter un procédé selon l'une des revendications 1 à 6.

8. Composant électronique selon la revendication 7, configuré pour tester au moins un autre composant électronique intégré dans le module (2).

9. Composant électronique selon la revendication 7 ou 8, configuré pour exécuter un auto-test.

10. Programme informatique doté de moyens de code de programme en vue d'exécuter toutes les étapes d'un procédé selon l'une des revendications 1 à 6 lorsque le programme informatique est exécuté sur un ordinateur ou une unité de calcul appropriée et en particulier dans un module électronique (2).

11. Produit de programme informatique doté de moyens de code de programme conservés en mémoire sur un support de données lisibles par ordinateur pour exécuter toutes les étapes d'un procédé selon l'une des revendications 1 à 6 lorsque le programme informatique est exécuté sur un ordinateur ou une unité de calcul appropriée, en particulier dans un module électronique (2).
